# EUROPÄISCHE PATENTSCHRIFT

(11) **EP 1 330 841 B1**
(45) Veröffentlichungstag und Bekanntmachung des Hinweises auf die Patenterteilung: **13.10.2004**
(21) Anmeldenummer: 01993020.5
(22) Anmeldetag: 25.10.2001
(51) Int. Cl.: H01L 21/68

(54) **VERFAHREN ZUR MONTAGE VON PLANAREN WERKSTÜCKEN**
METHOD FOR ASSEMBLING PLANAR WORKPIECES
PROCEDE POUR LE MONTAGE DE PIECES PLANES

(30) Priorität: 02.11.2000 DE 10054159
(43) Veröffentlichungstag der Anmeldung: 30.07.2003
(73) Patentinhaber: Siltronic AG, 81737 München (DE)
(72) Erfinder: SCHNEGG, Anton, 84489 Burghausen (DE); RURLÄNDER, Robert, 84533 Halsbach (DE); SCHNAPPAUF, Markus, 83024 Rosenheim (DE); HÜBEL, Thomas, 84478 Waldkraiburg (DE)
(74) Vertreter: Rimböck, Karl-Heinz, Dr.
(86) Internationale Anmeldenummer: PCT/EP2001/012368
(87) Internationale Veröffentlichungsnummer: WO 2002/037554

(56) Entgegenhaltungen:
- EP-A- 1 139 415
- WO-A-00/29128
- US-A- 4 803 124
- US-A- 5 234 530
- US-A- 5 681 757
- PATENT ABSTRACTS OF JAPAN vol. 015, no. 219 (E-1074), 5. Juni 1991 (1991-06-05) -& JP 03 062548 A (NEC YAMAGATA LTD), 18. März 1991 (1991-03-18)
- PATENT ABSTRACTS OF JAPAN vol. 2000, no. 01, 31. Januar 2000 (2000-01-31) -& JP 11 293224 A (THE INCTEC INC), 26. Oktober 1999 (1999-10-26)

## Beschreibung

Die Erfindung betrifft ein Verfahren zur Montage von planaren Werkstücken und insbesondere ein Verfahren zum Herstellen einer klebenden Verbindung zwischen einer Halbleiterscheibe und einer Trägerplatte, wobei mit einem Kitt zwischen der Halbleiterscheibe und der Trägerplatte eine temperaturabhängig klebende und temperaturabhängig versprödende Verbindung geschaffen wird. Gegenstand der Erfindung ist insbesondere ein Verfahren, bei dem eine Halbleiterscheibe zur Vorbereitung einer einseitigen Politur auf einer Trägerplatte fixiert wird.

Die Politur stellt in der Regel den letzten Arbeitsschritt dar, mit dem Unebenheiten, die auf den Seitenflächen der Halbleiterscheibe verblieben sind, beseitigt werden. Diese Unebenheiten stammen von vorangehenden Arbeitschritten wie Läppen oder Schleifen, die der Formgebung der Halbleiterscheiben dienen. Das gewünschte Endprodukt ist eine Halbleiterscheibe mit möglichst ebenen und parallelen Seiten, die zur Herstellung elektronischer Bauelemente geeignet ist. Es ist bereits bekannt, Halbleiterscheiben (Wafer) auf Trägerplatten zu fixieren, um sie bearbeiten zu können, wie beispielsweise in der DE-A 19756614 beschrieben. Zum einen kann die Scheibe in einer Führung (Ring) gehalten werden, wobei die Auflage - meist ein geschäumtes PUR-Tuch oder eine Folie - durch verschiedenste Verfahrensvariationen eine Vorform erhält. Die zweite Möglichkeit besteht darin, dass die Scheibe mittels Vakuum gegen die Referenzfläche gesaugt wird, wobei häufig die Gefahr besteht, dass die Abdichtung nicht perfekt ist und damit einerseits die Scheibe verrutscht und andererseits Poliermittel auf die Scheibenrückseite gelangt und diese verätzt. Diese Arten der Scheibenhalterung werden vorzugsweise bei Einzelscheiben-Prozessen angewendet. Ein Nachteil dieses Verfahrens ist, dass die Auflage als Referenzebene wenig genau definiert ist.
Bei der zweiten Form der Fixierung verwendet man einen Kleber, der die Scheibe auf einem metallischen oder keramischen Träger hoher mechanischer Formbeständigkeit fixiert. Diese Ebene ist gleichzeitig die Referenzebene für die zu polierende Geometrie der Scheibe. Hier werden zwei Varianten angewendet.
A) Bei der Belackung der Scheibe mit dem Kleber, meist durch Auf spinnen des Klebers in einer gelösten Form, wird die Oberfläche des Klebers letztendlich nach Trocknung und Heizen in den schmelzflüssigen Bereich des Klebers auf die Oberfläche der Trägerplatte als Referenzfläche gedrückt. Unebenheiten der Wafer-Rückseite werden dabei mehr oder weniger vollständig im Kitt versteckt. Nachteil dieses Verfahrens ist das rheologische Verhalten der Kittlösung. Zum einen lässt sich ein Zentrumsartefakt (Fehler) wegen des Schleudervorgangs nicht vermeiden. Zum anderen wird sich immer ein Randwulst am Scheibenrand aufbauen, der durch Pressen der Wafer auf den Träger nicht vollständig zu eliminieren ist. Diese Problemzonen sind geometrisch häufig im 1/10 µm-Bereich nachzuweisen.
B) Beim Belacken der Trägerplatte mittels Aufspinnen der Kittlösung können grundsätzlich dieselben Problemzonen entstehen, jedoch wird die Trägerplatte i.a. nicht im Zentrum oder im kritischen Randbereich mit Wafern belegt, so dass diese Fehler nicht auf die Scheibe übertragen werden. Ein Nachteil dieses Verfahrens ist, dass sich die von den Vorprozessen noch auf der Scheibenrückseite befindlichen Unebenheiten im Nanometerbereich nicht vollständig in den Kitt einpressen lassen und durch die anschließende Politur auf die Scheibenvorderseite kopiert werden. Gleiches gilt auch für Unebenheiten, die sich beim Trocknen des Kitts und Aufheizen in den Bereich der Haftzone des Klebers entwickeln. Diese als Nanotopologie bezeichnete Welligkeit (Waviness) mit kurzwelligen Steigungen im Millimeter-Bereich und mit Höhenunterschieden im Bereich von bis zu 50 nm wird auf die Wafer-Vorderseite kopiert und wirkt sich bei anschließenden Prozessen in der Bauelementfertigung negativ aus.

In der US-5,681,757 ist ein Verfahren zum Herstellen einer klebenden Verbindung zwischen einem Mikrochip und einem Substrat offenbart, wobei die Verbindung über ein Muster von Mikrotropfen eines Klebers hergestellt wird. Die EP-1139415 A1 beschreibt ein wasserdurchlässiges klebendes Band zum Bearbeiten von Halbleiterscheiben.

Die vorliegende Erfindung löst die Aufgabe, die Nanotopologie einer einseitig polierten Halbleiterscheibe zu verbessern und insbesondere eine lokale Erhebung im Zentrum der Halbleiterscheibe (Centermark-Fehler) zu vermeiden.

Gegenstand der Erfindung ist ein Verfahren zur Montage von planaren Werkstücken gemäß dem Anspruch 1.

Erfindungsgemäß wird keine vollflächig zusammenhängende Kittschicht zwischen der Halbleiterscheibe und der Trägerplatte angestrebt. Vielmehr sind auch kittfreie Zonen zwischen der Halbleiterscheibe und der Trägerplatte vorzusehen. Dieses Vorgehen hat verschiedene vorteilhafte Wirkungen. Zum einen kann komprimierter Kitt beim Aufpressen der Halbleiterscheibe auf die Trägerplatte in kittfreie Zwischenräume ausweichen. Gleiches gilt auch für Luft, die nicht mehr im Kitt eingeschlossen werden kann. Mögliche, differentielle Druckunterschiede beim Aufpressen der Halbleiterscheibe werden ausgeglichen. Störungen durch Partikel sind seltener und Centermark-Fehler treten überhaupt nicht mehr in Erscheinung. Generell werden systematische Fehler einer Spinntechnology (z.B. Pictureframing) vermieden.

Beispiele für die im erfindungsgemäßen Verfahren eingesetzten planaren Werkstücke sind Halbleiterscheiben sowie mit hoher Oberflächenplanarität zu polierende Werkstücke, wie etwa für optische Systeme, wobei Halbleiterscheiben bevorzugt und Silicium-Wafer besonders bevorzugt sind.

Bei dem erfindungsgemäßen Verfahren können als Kitt alle Stoffmischungen eingesetzt werden, die temperaturabhängig eine Klebewirkung zeigen. Beispiele für solche Kitte sind Copolymere auf Pyrrolidonbasis sowie Stoffmischungen auf der Basis von Kolophoniumharz, wie sie beispielsweise auch bisher in Verfahren zur Montage von Halbleiterscheiben auf Trägerplatten verwendet wurden.

Vorzugsweise handelt es sich bei dem im erfindungsgemäßen Verfahren eingesetzten Kitt um Stoffmischungen enthaltend mit Amin verseiftes Kolophoniumharz, wobei mindestens einer der Reste am Amin der Rest eines aliphatischen Alkohols ist, und der Siedepunkt des Amins bei einem Druck von 1000 mbar größer als 150°C ist, gegebenenfalls im Gemisch mit Füllstoffen.

Beispiele für die im erfindungsgemäß eingesetzten Kitt enthaltenen Kolophoniumharze sind beliebige, kommerziell erhältliche Kolophoniumharze, wie etwa unter dem Handelsnamen M-1XX von Arizona Chemical, USA, vertriebenes, wobei XX eine laufende Produktnummer ist. Das Kolophoniumharz wird vorzugsweise durch Vakuumdestillation aus Roh-Tallöl ("crude tall oil") gewonnen und chemisch modifiziert und verestert. Bevorzugt ist, dass das Kolophoniumharz durch Reaktion mit einer Verbindung, ausgewählt aus der Gruppe bestehend aus Maleinsäure, Maleinsäureanhydrid und Fumarsäure, chemisch modifiziert wird. Anschließend wird das modifizierte Harz mit einem Alkohol verestert, der vorzugsweise aus einer Gruppe ausgewählt ist, die Glycerin und Pentaerythrit umfasst. Bevorzugt hat das chemisch modifizierte und veresterte Kolophoniumharz eine Säurezahl von 50 bis 250 [mg KOH/g Harz], einen Erweichungspunkt von 60 bis 180°C und ein Molekulargewicht M_{w} (Gewichtsmittel) von 1200 bis 4000.

Bevorzugt handelt es sich bei den Aminen, mit denen die chemisch modifizierten und veresterten Kolophoniumharze verseift werden können, um wäßrige Lösungen von Triethanolamin, Triisopropanolamin, Diisopropanolamin oder Diethanolamin, wobei die Harzseife dabei in der wäßrigen Phase in Lösung geht.

Die zur Herstellung des im erfindungsgemäßen Verfahren verwendeter. Kitts eingesetzte Menge an Lösungsmittel, wie Wasser bzw. organischem Lösungsmittel, ist abhängig von der gewünschten Viskosität für den Auftragungsprozess.

Beispiele für Füllstoffe, die zur Herstellung des im erfindungsgemäßen Verfahren verwendeten Kitts eingesetzt werden können, sind Ruße, Pigmente, TiO₂, Fe₂O₃, CeO₂, Rutil, Anatas, SiO₂-Sol, hochdisperse Kieselsäure, organische Polymere wie Polyethylen, Polypropylen, Polyamid oder Polyurethan, insbesondere in Pulverform, thixotrope Polymere, derivatisierte Kohlenhydrate, Cellulose und Celluloseether. Welche Art von Füllstoff zur Herstellung der erfindungsgemäßen Stoffmischung eingesetzt wird, hängt unter anderem von dem gewünschten Grad an Hydrophilie bzw. von der mechanischen Härte der Klebeschicht ab.

Bevorzugt handelt es sich bei den im erfindungsgemäßen Verfahren eingesetzten Kitten um wasserfreie und wasserhaltige Stoffmischungen mit der folgenden Zusammensetzung:
10 bis 100 Gew.-% chemisch modifiziertes und verestertes Kolophoniumharz vollständig verseift mit Amin,
0 bis 10 Gew.-% anorganischen Füllstoff,
0 bis 2 Gew.-% Hilfsstoffe, wie Tenside, alkoholische Lösevermittler sowie Farbstoffe, und
Wasser in einer die Summe der Mengenangaben zu 100 Gew.-% ergänzenden Menge.

Falls bei der erfindungsgemäßen Stoffmischung Tenside, insbesondere zur Anpassung an den gewünschten Haftzonenbereich, eingesetzt werden, was nicht bevorzugt ist, handelt es sich vorzugsweise um nicht-ionische Tenside, insbesondere um Nonylphenolpolyether, die als Weichmacher wirken können.

Falls bei der erfindungsgemäßen Stoffmischung alkoholische Lösevermittler, insbesondere zur Beschleunigung des Lösevorgangs, eingesetzt werden, was nicht bevorzugt ist, handelt es sich vorzugsweise um Isopropanol.

Falls bei der erfindungsgemäßen Stoffmischung Farbstoffe, insbesondere zur visuellen Kontrolle der Schichtdicke, eingesetzt werden, handelt es sich vorzugsweise um Kristallviolett, Fluoreszenzfarbstoffe, wie Rhodamin B und Eosin, und intensiv färbende wasserlösliche Farbstoffe, wie Malachitgrün.

Besonders bevorzugt besteht die erfindungsgemäße Stoffmischung aus
25 bis 100 Gew.-% chemisch modifiziertem und verestertem Kolophoniumharz vollständig verseift mit Triethanolamin,
0 bis 10 Gew.-% anorganischem Füllstoff,
0 bis 2 Gew.-% Hilfsstoffe, wie Tenside, alkoholische Lösevermittler sowie Farbstoffe, und
Wasser in einer die Summe der Mengenangaben zu 100 Gew.-% ergänzenden Menge.

Bei dem erfindungsgemäßen Verfahren kann der Kitt entweder auf die Oberfläche der Trägerplatte oder die Oberfläche des planaren Werkstücks, also bevorzugt der Halbleiterscheibe, aufgetragen werden. Es kann auch der Kitt sowohl auf die Trägeroberfläche als auch auf die Oberfläche der Halbleiterscheibe aufgetragen werden, was jedoch schon aus verfahrensökonomischer Sicht nicht bevorzugt ist. Die im erfindungsgemäßen Verfahren eingesetzte Trägerplatte kann in Größe und Geometrie der zu fixierenden Halbleiterscheibe entsprechen. Die eingesetzte Trägerplatte kann aber auch größer als die zu fixierende Halbleiterscheibe sein, so dass auf einer Trägerplatte mehrere Halbleiterscheiben gleichzeitig fixiert werden können, was bevorzugt ist.

Im Sinne der vorliegenden Erfindung soll unter der Bezeichnung große Trägerplatte eine Trägerplatte verstanden werden, auf der mehrere Halbleiterscheiben fixiert werden können, besonders bevorzugt deren Durchmesser 2-4-fach so groß ist wie der Durchmesser der Halbleiterscheibe.

Setzt man eine große Trägerplatte ein, kann die gesamte Oberfläche mit Kitt beschichtet werden oder nur die Bereiche, auf die später die Halbleiterscheiben aufgelegt werden. Letzteres hat den Vorteil, dass weniger Kitt aufgewendet werden muß und dass die verwendeten Werkzeuge klein und damit leichter zu bearbeiten sind. Es kann aber auch, je nach Anwendungsbedingungen von Vorteil sein, die Trägerplatte als ganzes zu beschichten, wenn sich daraus z.B. Reinraum-gerechteres Arbeiten im Einzelfall ableiten lässt.

Bei dem erfindungsgemäßen Verfahren hat die Beschichtung einer großen Trägerplatte mit Kitt den Vorteil, dass mit einer Beschichtung mehrere Halbleiterscheiben fixiert werden können. Die Beschichtung der einzelnen Halbleiterscheibe hat den Vorteil, dass die Dimension der angewandten Hilfsmittel kleiner gewählt werden kann, was mit geringerem apparativen Aufwand verbunden ist. Bei dem erfindungsgemäßen Verfahren wird der Kitt daher bevorzugt auf die Halbleiterscheibe mit der Maßgabe aufgebracht, dass die zu verbindenden Oberflächen der Trägerplatte und der Halbleiterscheibe nach dem Auflegen der Halbleiterscheibe auf die Trägerplatte jeweils nur zum Teil mit Kitt bedeckt sind.

Zu verbindende Oberfläche im Sinne der vorliegenden Erfindung bedeutet in Bezug auf die Halbleiterscheibe die Seitenfläche, mit der die Halbleiterscheibe auf der Trägerplatte liegt und in Bezug auf die Trägerplatte den Oberflächenanteil, der von der auf der Trägerplatte liegenden Halbleiterscheibe bedeckt ist.

Bei dem erfindungsgemäßen Verfahren sind bevorzugt maximal 75 % der zu verbindenden Oberflächen mit Kitt bedeckt. Die Untergrenze ist beliebig, ergibt sich jedoch im allgemeinen aus Stabilitätskriterien bei der Fixierung. Es muss ausreichend Kitt vorhanden sein, damit sich die Halbleiterscheibe beim Polieren nicht von der Trägerplatte ablöst. Besonders bevorzugt sind bei dem erfindungsgemäßen Verfahren 10 bis 50 % der zu verbindenden Oberflächen mit Kitt bedeckt.

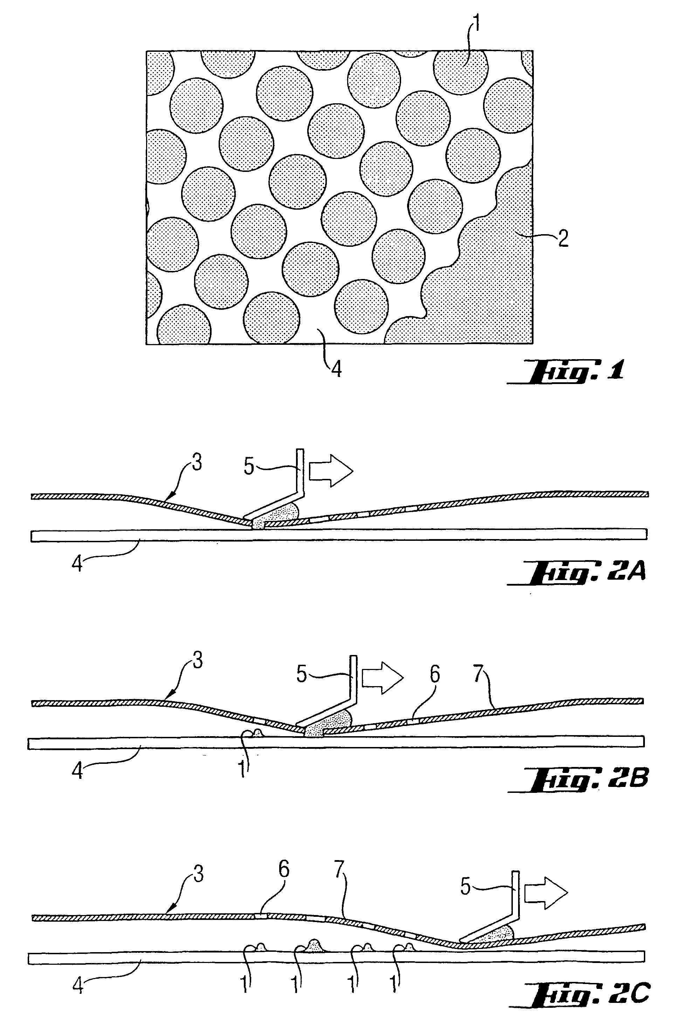

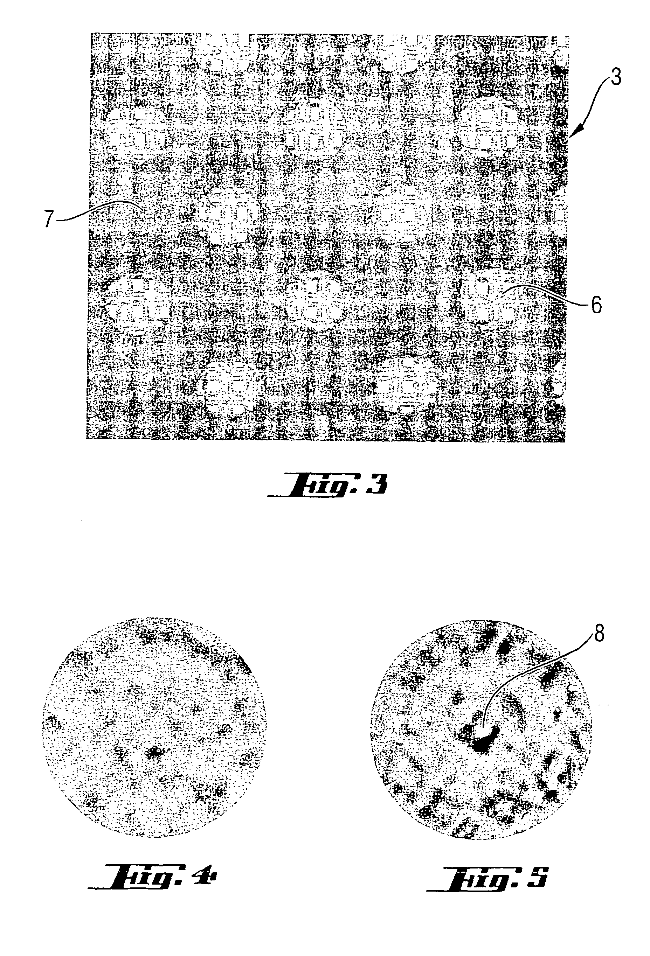

Im Folgenden werden mögliche Ausführungsformen des erfindungsgemäßen Verfahrens beschrieben. Eine besonders bevorzugte Ausführungsform wird darüber hinaus mit Hilfe von Figuren näher erläutert. Figur 1 zeigt eine bevorzugte Verteilung von Kittpunkten. In Fig.2 ist das Prinzip des Siebdrucks gemäß der bevorzugten Verfahrensvariante d) dargestellt. Figur 3 zeigt die mikroskopische Aufnahme eines Siebs, das zur Durchführung dieser Verfahrensvariante geeignet ist. In den Figuren 4 und 5 sind die Ergebnisse einer nanotopologischen Untersuchung der Oberflächen zweier Halbleiterscheiben vergleichend dargestellt, wobei nur die Halbleiterscheibe gemäß Figur 4 erfindungsgemäß poliert wurde.

### Verfahrensvariante a):

In der erfindungsgemäßen Verfahrensvariante a) wird der einzusetzende Kitt soweit erwärmt, bis er eine gießfähige Konsistenz hat, was bevorzugt einer Viskosität von 1 000 bis 100 000 mm²/s, besonders bevorzugt 10 000 bis 100 000 mm²/s, entspricht. Die Temperatur, bei welcher der Kitt eine Viskosität in diesem Bereich hat, liegt bevorzugt oberhalb der Haftzone, wo sich die Viskosität i.a. stark mit der Temperatur ändert. Mit Haftzone ist der Temperaturbereich gemeint, in dem der Kitt seine klebende Wirkung am wirksamsten entfaltet. Die im erfindungsgemäßen Verfahren angewendete maximale Temperatur sollte 110°C nicht übersteigen, da bei einer längeren Dauer erste Zersetzungsprodukte entstehen, die sich negativ auf die Hafteigenschaften auswirken können. In der erfindungsgemäßen Verfahrensvariante a) wird dann der erwärmte Kitt mit einer üblichen Zahnrakel, wie sie z.B. in der Bauchemie bekannt ist, auf die zu beschichtende Oberfläche aufgetragen. Mit der jeweils gewählten Viskosität des Kitts lassen sich die Filmdicken des Kitts besonders leicht einstellen, bevorzugt im Bereich von 1 bis 50 µm. Besondere Beachtung beim Aufrakeln ist der geometrischen Perfektion der Rakel bzw. der Führung der Rakel in lateraler Richtung zu schenken. Als einfachere Variante bei der erfindungsgemäßen Verfahrensvariante a) hat sich das Drehen der Trägerplatte unter der Rakel herausgestellt. Dabei ist der Randbereich der Trägerplatte gleichmäßiger bestrichen als das Zentrum. Das Zentrum ist bei großen Trägerplatten für die Politur meist ohne Belang, da im allgemeinen das Zentrum nicht mit einer Halbleiterscheibe versehen wird. Bei der beschriebenen Verfahrensvariante bildet der Kitt einen Belag aus parallel liegenden Streifen, die durch kittfreie Bereiche getrennt sind.

### Verfahrensvariante b):

In der erfindungsgemäßen Verfahrensvariante b) wird der Kitt extern zwischen zwei Trennpapieren ausgewalzt, wobei - wie im Verfahren a) beschrieben - unter Zuhilfenahme von thermischer Energie der Kitt auf eine plastische Konsistenz eingestellt, was bevorzugt einer Viskosität von 50 000 bis 200 000 mm²/s, besonders bevorzugt 70 000 bis 150 000 mm²/s, entspricht und zu Folien von bevorzugt 5 bis 50 µm Dicke verarbeitet wird. Nach Entfernen eines der Trennpapiere wird die so erhaltene Folie mittels einer profilierten Walze auf das Substrat (die Halbleiterscheibe oder die Trägerplatte) aufgewalzt und die zweite Trennfolie abgezogen.

In der erfindungsgemäßen Verfahrensvariante b) liegen die erreichten Dickentoleranzen der Kittfolien langwellig bevorzugt bei << 1 µm. Diese Dickenschwankungen stören wegen ihrer Langwelligkeit, die aus der Geometrie der Walze und dem Transport der Trägerplatte durch das Walzenpaar herrührt, die globale Geometrie der Wafer nicht. Nanotopologische Effekte mit Welligkeiten von einigen mm und Höhen von 10 bis 50 nm treten nicht auf.

### Verfahrensvariante c):

In der erfindungsgemäßen Verfahrensvariante c) wird der Kitt in Pulverform mit einem Kornspektrum von bevorzugt 0,5 bis 5 µm, besonders bevorzugt 0,5 bis 4 µm, eingesetzt. Ein Beispiel für einsetzbaren Kitt ist ein solcher mit einem Kornspektrum von 0,5 bis 1,0 µm für dünnere Kittschichten und 2,0 bis 5 µm für dickere Kittschichten. Das erfindungsgemäß eingesetzte Kittpulver kann nach bekannten Verfahren, wie Feinmahlen plus Klassieren oder über einen Sprühteller sowie Fällung einer Kittlösung erhalten werden. In letztem Fall wird bevorzugt eine Lösung von Kitt in Wasser eingesetzt und mit starker Mineralsäure, wie HCl oder H₂SO₄ gefällt. Die Trägerplatte - oder einfacher die Halbleiterscheibe - wird bei der erfindungsgemäßen Verfahrensvariante c) elektrostatisch bis >> 10 kV aufgeladen.

Das Kittpulver wird in einem Wirbelbett umgekehrt aufgeladen und mittels einer Sprühpistole in einer Verdünnung von 1:1000 bis 1:10000 in einem Treibgas über die zu beschichtende Oberfläche geblasen und damit ein Teil der zu beschichtenden Oberfläche mit Kitt belegt. wegen der starken Anziehung der Partikel vom Substrat her und wegen der starken Abstoßung untereinander entsteht unterstützt durch die hohe Verdünnung eine Schicht von monodispersen Partikeln. Durch Erhöhen der Temperatur bei der erfindungsgemäßen Verfahrensvariante c) wird der Kitt in die Haftzone gebracht und auf die vorgewärmte, unbeschichtete Trägerplatte bzw. Halbleiterscheibe gedrückt. Vorteil der Trägerplatten-Beschichtung ist der relativ geringere Aufwand, da mit einer Beschichtung mehrere Wafer zur Montage kommen. Die Beschichtung der einzelnen Halbleiterscheibe hat dagegen den Vorteil, dass die Apparaturen wesentlich kleiner gebaut und gegen eine zusätzliche Partikelkontamination besser geschützt werden können. Dies hat eine hohe Bedeutung, da ein Einbetten von größeren Partikeln unweigerlich zu "Grübchen" (Dimple) führen, welche die Wafer unbrauchbar machen würden.

Die besonders bevorzugten Verfahrensvarianten d) und e) betreffen Drucktechniken, mit deren Hilfe der Kitt aufgetragen wird. Diese Techniken haben gemeinsam, dass der Kitt an ausgewählten Stellen von vorzugsweise der Halbleiterscheibe oder gegebenenfalls auch der Trägerplatte aufgetragen werden kann. Die gedruckten Kittmuster haben in der Draufsicht vorzugsweise das Aussehen punktförmiger Inseln. Die Inseln haben einen bestimmten Durchmesser, eine bestimmte Dichte, die gegebenenfalls lokal unterschiedlich sein kann und eine bestimmte, ausgewählte Höhe. Die Punktdichte beträgt vorzugsweise 10 bis 100 Punkte/cm, besonders bevorzugt 10 bis 40 Punkte/cm. Die Punktdurchmesser liegen vorzugsweise in einem Bereich von 50 bis 500 µm, besonders bevorzugt von 50 bis 400 µm. Die Punkthöhe beträgt vorzugsweise 1 bis 20 µm, besonders bevorzugt 2 bis 5 µm. Durchmesser, Höhen und Formen der Kittpunkte sind insbesondere über die Viskosität und das Fließverhalten des Kitts und die eingesetzte Drucktechnik einstellbar. Der Punktabstand wird entsprechend der Vorgaben in Bezug auf die Punktdichte, die Punkthöhe und den Punktdurchmesser gewählt. Die Kittpunkte können gleichmäßig über die bedruckte Fläche verteilt sein. Gemäß einer bevorzugten Ausführungsform der Erfindung sind die Durchmesser der Kittpunkte in einem Randbereich der Halbleiterscheibe größer als in einem Zentrumsbereich der Halbleiterscheibe oder die Dichte der Kittpunkte ist bei Kittpunkten mit gleichem Durchmesser im Randbereich der Halbleiterscheibe höher als im Zentrumsbereich. Schließlich können die Kittpunkte im Randbereich der Halbleiterscheibe auch einen geschlossenen Kittfilm bilden. Dies ist insbesondere bei wasserlöslichen Kitten von Vorteil, da durch die genannten Maßnahmen einem Anlösen oder Unterspülen der Kittpunkte durch eindringende Feuchtigkeit, beispielsweise durch eindringendes Poliermittel entgegengewirkt, wird. Figur 1 zeigt einen Bereich von gleichmäßig verteilten Kittpunkten 1 und einen Randbereich, an dem die Kittpunkte zu einem zusammenhängenden Kittfilm 2 verschmolzen sind.

Eine besondere Ausführungsform der Erfindung sieht vor, die lokale Unterstützung der Halbleiterscheibe durch Kittpunkte derart zu wählen, dass die Halbleiterscheibe durch das Polieren gezielt eine konvexe oder konkave Form erhält. Dies ist insbesondere dann bevorzugt, wenn der Politur eine Schleierfrei-Politur ohne nennenswerten Materialabtrag (mirror polishing) oder eine andere einseitige Behandlung oder Beschichtung nachgeschaltet wird, die die Form der Halbleiterscheibe verändert, und die Formänderung dazu führt, dass die Halbleiterscheibe am Ende der Prozesskette als ideal eben angesehen werden kann.

Gemäß einer weiteren besonderen Ausführungsform der Erfindung wird die Form der zu polierenden Halbleiterscheibe untersucht und es werden solche Stellen auf der zu polierenden Seite der Halbleiterscheibe bestimmt, die bei der nachfolgenden Politur bevorzugt abzutragen sind. Der Kitt wird dann bevorzugt oder in verstärktem Maß gegenüber den genannten Stellen auf der Seite der Halbleiterscheibe aufgetragen, die mit der Trägerplatte verbunden wird. Auch mit dieser Maßnahme wird das Ziel verfolgt, eine Halbleiterscheibe mit einer möglichst eben polierten Seite zu erhalten.

### Verfahrensvariante d) :

Bei der erfindungsgemäßen Verfahrensvariante d) wird der Kitt als dickflüssige Masse in Siebdruck-Technik durch ein strukturiertes Druck-Sieb gerakelt und dabei vorzugsweise auf die Halbleiterscheibe aufgedruckt. Der Kitt hat eine Viskosität im Bereich von vorzugsweise 5 bis 100 000 mm²/s, besonders bevorzugt 50 bis 10 000 mm²/s, jeweils bezogen auf 25°C. Dabei müssen die Abmessungen des Siebs, des Klischees (Siebgrundkörper) und die Fließeigenschaften der Kittmasse zueinander passen. Weitere das Druckergebnis beeinflussende Größen sind das Siebmaterial und dessen Absprungverhalten, die Maschenweite und die Fadenstärke. Für das Sieb können sowohl Fäden aus Kunststoff, beispielsweise Polyester, als auch aus Metall, beispielsweise Stahl oder Messing verwendet werden. Bei der Auswahl des Siebes ist darauf zu achten, dass das Verhältnis der mittels Photolack erstellten nicht-durchlässigen Stellen zu den für den Kitt durchlässigen Bereichen groß genug-ist, um die Kittpunkte deutlich voneinander zu trennen. Andererseits müssen die Kittpunkte nahe genug beieinander liegen, damit sich kein Muster der Kittpunkte beim Polieren der Halbleiterscheibe auf die polierte Seite der Halbleiterscheibe überträgt.

Das Prinzip des Siebdruck-Verfahrens ist in Fig.2 dargestellt. Folgender Ablauf hat sich als besonders geeignet herausgestellt. Das strukturierte Sieb 3 wird über dem Substrat 4, vorzugsweise über der mit der Trägerplatte zu verbindenden Seite der Halbleiterscheibe angeordnet. Das Sieb wird beim Druckvorgang nicht auf das Substrat aufgelegt, sondern in Abhängigkeit der Eigenschaften des Kitts in geringer Entfernung vom Substrat gehalten. Nachdem das Sieb mittels Füllrakel mit Kitt gefüllt ist, wird in einem weiteren Schritt das im Sieb befindliche Volumen des Kitts mittels einer Druckrakel 5 auf das Substrat 4 gepresst. Das dabei stark gedehnte Siebgewebe springt unmittelbar hinter der Rakel vom Substrat ab und erzeugt ein sehr gleichmäßiges Druckbild an Kittpunkten 1, deren Abstand und Anordnung dem Klischee vorgegeben wurden. In Fig.3 ist ein geeignetes Sieb 3 dargestellt. Man kann deutlich die runden, kittdurchlässigen Flächen 6 (Durchlasspunkte) von den kittundurchlässigen Bereichen 7 unterscheiden. Der Abstand des Siebs vom Substrat ("Absprung") ist einzustellen in Abhängigkeit der Viskosität des verwendeten Kitts und der Größe der Durchlasspunkte im Klischee. Es ist bevorzugt, dass das Sieb die Oberfläche der Halbleiterscheibe beim Aufrakeln des Kitts nur punktuell berührt. Über den Lösemittelanteil der Kittmasse und die Höhe der Kittpunkte wird die Höhe der Kittschicht eingestellt, wobei die Schrumpfung der Menge des verdampften Lösemittels proportional ist.

Versuche haben gezeigt, dass sich in Lösemittel, bevorzugt in Wasser gelöster Kitt, ohne dass eine erhöhte Temperatur zur Reduzierung der Viskosität eingesetzt werden muss, in dem Viskositätsbereich von etwa 50 bis etwa 10000 mm²/s problemlos bei Raumtemperatur verwenden lässt. Dies entspricht Wassergehalten von ca. 65 bis 40 Gew.-%, bezogen auf die Gesamtmasse der Kittrezeptur. Mit zunehmendem Wassergehalt, entsprechend abnehmender Viskosität, schrumpft die Kittmasse, wobei je nach Viskosität des Kittes unterschiedliche Endformen resultieren. Bei höher viskosen Kitten besitzt ein Kittpunkt eine säulenförmige Struktur, während niedrig viskose Kittlösungen eher Kittpunkte erzeugen, die Halbkugel-Kalotten entsprechen. Niedrig viskose Kittlösungen eignen sich besonders dann, wenn dünne Klebeschichten angestrebt werden. Generell kann das Fliessverhalten des Kitts nach dem Auftragen mittels Siebdruck auch dadurch beeinflusst werden, dass der Kittrezeptur zusätzlich Tensid zugesetzt wird, beispielsweise Triethanolamin. Damit wird zwar die Haftzone weiter herabgesetzt, womit die Klebewirkung bei niedrigen Temperaturen erhöht wird, beim Abkitten der Scheiben wirkt sich dies jedoch nur wenig aus, da die zu trennende Fläche nur einem Teil der Seitenfläche der Halbleiterscheibe entspricht.

Da beim Rakeln eine große Oberfläche des Kitts immer neu erzeugt wird, nimmt die Viskosität der Kittmasse mit dem verdunsten des Lösemittels ständig zu. Eine höhere Viskosität hat einen geringeren Schrumpfungsgrad zur Folge und damit einen höheren Kittauftrag. Dies kann durchaus gewünscht sein. Für eine sichere und konstante Prozessführung sollte die Viskosität des Kittes allerdings in möglichst engen Grenzen gehalten werden, weil damit auch vermieden wird, dass der Kitt auf dem Sieb zu trocknen beginnt. Dies geschieht vorzugsweise dadurch, dass das Sieb mittels einer Haube von der Umgebung abgeschirmt wird und der entstehende Innenraum gegebenenfalls mit zusätzlich angefeuchteter Luft überspült wird. Ein konstanter Wasserdampfdruck von vorzugsweise 6 kg/m³ Luft ist bei Verwendung eines wasserlöslichen Kitts besonders bevorzugt. Einfacher lässt sich die Konstanz der Viskosität dadurch erhalten, dass dem System die durch den Druckvorgang verloren gegangene Menge an Kitt kontinuierlich durch einen um die Menge des verdunsteten Wassers oder Lösemittels verdünnteren Kitt zugeführt wird. Diese Regelung ist bei kontinuierlichem Betrieb sehr einfach, da die verbrauchte Menge an Kitt konstant und durch Wägung leicht zu bestimmen ist.
Eine andere Möglichkeit die Viskosität des Kittes konstant zu halten besteht darin, dass man einen Kitt verwendet, der frei von Lösemittel ist. Die Viskosität wird durch Temperieren des Kitts eingestellt. Dies geschieht vorteilhaft mittels direkten Stromdurchgangs durch ein metallisches Sieb. Die benötigten Temperaturen liegen dabei kurzfristig im Bereich von 60 bis 115°C, entsprechend einer Viskosität von 100 000 bis 30 000 mm²/s.

Eine regelmäßig durchgeführte Reinigung des Siebs ist anzuraten, da selbst unter Reinraumbedingungen noch vorhandene Partikel einzelne Poren des Siebs zusetzen können und damit das Druckbild stören. Der Ausfall eines einzelnen Kittpunktes bewirkt wegen der hohen Anzahl der Punkte bezogen auf die Flächeneinheit noch keinen geometrischen oder nanotopologischen Effekt auf der polierten Halbleiterscheibe, sollte aber zum Erreichen eines exzellenten Qualitätsniveaus vermieden werden. Deshalb wird das Sieb vorzugsweise regelmäßig gereinigt. Als Reinigungsmittel eignet sich insbesondere ein den Kitt lösendes Lösemittel, wobei eine rotierende Bürste als Reinigungswerkzeug die Reinigung beschleunigt. Wesentlich einfacher ist die Verwendung rotierender Düsen als Reinigungswerkzeuge, beispielsweise solche, die in haushaltsüblichen Spülmaschinen verwendet werden. Insbesondere bei Wasser als Lösemittel lässt sich die Reinigung sehr einfach gestalten, indem das Anlösen des Kitts im Umpumpverfahren, das Freispülen mit frischem Wasser oder einem anderen Lösemittel durchgeführt wird. Um das Sieb anschließend zu trocknen, bläst man beispielsweise Luft oder Stickstoff durch dasselbe rotierende Düsensystem oder besser durch ein separates Düsensystem, das der geringeren Viskosität des Gases angepasst ist. Beim Einfahren eines neuen oder gereinigten Siebs kann es beim ersten Druck zu uneinheitlichem Kitt-Auftrag kommen. Um dies sicher auszuschließen druckt man vorzugsweise zunächst auf Dummyscheiben, Papier oder eine Folie, bis das Druckbild die benötigte Qualität aufweist. Als besonders vorteilhaft hat sich die Verwendung einer Folie herausgestellt.

Alternativ zur oben beschriebenen Siebdrucktechnik lassen sich verwandte Verfahren anwenden, wie z.B. der Hochdruck oder die besondere Ausführungsform des Flexodrucks, wobei aus einer Vorratswalze mit gezielt eingestellter Anzahl und Tiefe von Näpfen über eine Walze, die das Punktklischee trägt, der Kleber auf das zu bedruckende Substrat übertragen wird.

Bei der erfindungsgemäßen Verfahrensvariante d) hat das bevorzugte Bedrucken der Halbleiterscheibe auch den Vorteil, dass die thermische Masse zum Verdampfen des Lösemittels wesentlich kleiner ist als beim Bedrucken einer großen Trägerplatte. Allerdings sollte Sorge getragen werden, dass die zu polierende Seite der Halbleiterscheibe beim erfindungsgemäßen Beschichten nicht verletzt wird.

### Verfahrensvariante e):

Bei der erfindungsgemäßen Verfahrensvariante e) wird der Kitt als dickflüssige Masse im Tintenstrahldruck-Verfahren appliziert. Die Viskosität des Kitts ist abhängig vom Düsenabstand des Druckkopfes und so eingestellt, dass die einzelnen Kittpunkte sich nicht berühren und auch unter dem Anpressdruck des Wafers noch genügend Zwischenraum lassen, dass eingeschlossene Luft entweichen kann bzw. Unebenheiten des Wafers durch Fließen des Kitts ausgeglichen werden können.

Die Einstellung der Viskosität kann mittels Lösemittel, wie etwa organischem Lösungsmittel, wie z.B. Isopropanol oder Toluol, oder Wasser, vorgenommen werden, wobei Wasser bevorzugt ist. Hierbei ist darauf zu achten, dass der Kittpunkt im anschließenden Trocknungsschritt schrumpft und somit seine Abmessungen um den Faktor des prozentual zugesetzten Lösemittels verändert. Die Form des Kittpunktes wird dabei nur geringfügig verändert, die Grundform, meist eine symmetrische Rundung der Spitze, bleibt weitestgehend erhalten.

Eine weitere Ausführungsform der erfindungsgemäßen Verfahrensvariante e) besteht in der Verwendung eines Lösemittel-freien Kitts, dessen Viskosität durch Temperatursteuerung im Druckerkopf auf einen Sollwert eingestellt wird. Diese Vorgehensweise hat den Vorteil, dass ein separater Trocknungsschritt und die dabei auftretende Form- und Volumenänderung nicht stattfindet.

In Anwendung können übliche Ink-Jet-Köpfe kommen, bei welchen die Kittpunkte durch die dpi charakterisiert sind (dots per inch) und es lassen sich Kittpunkt-Abstände von ca. 40 µm (20 µm) erzeugen. Generell lassen sich durch die Größe und Anzahl der piezoelektrisch angesteuerten Druckdüsen sowie durch die Ansteuerung des Düsenkopfes Abstand und Größe der Kittpunkte einstellen. Abstände von > 1mm sind zu vermeiden, da dabei schon durch die Durchbiegung der Halbleiterscheibe eine geringe Waviness (Nanotopologie) erzeugt wird.

Bei der erfindungsgemäßen Verfahrensvariante e) beträgt die Viskosität des eingesetzten Kitts bevorzugt 5 bis 100 000 mm²/s, besonders bevorzugt 50 bis 10000 mm²/s (Lösungsmittelkitt), jeweils bei 25°C für wasserhaltigen Kitt, bzw. 10000 bis 100 000 mm²/s bei 60 bis 115°C für lösemittelfreien Kitt. Bei dem erfindungsgemäßen Verfahren kann nach erfolgter Beschichtung der zu verbindenden Oberflächen gemäß einer der vorgeschlagenen Verfahrensvarianten a) bis e) nach bekannten Arbeitsweisen weiter verfahren werden. Die erfindungsgemäß hergestellte Beschichtung trocknet zu einer temperaturabhängig klebenden und physikalisch versprödenden Masse. Die Klebewirkung der Masse entfaltet sich nur innerhalb eines schmalen Temperaturbereiches (Haftzone, "sticking zone") von vorzugsweise 40 bis 80°C. Die Klebewirkung lässt wie beieinem Schmelzkleber nach, wenn die Masse über eine obere Temperatur der Haftzone erhitzt wird. Ebenfalls lässt die Klebewirkung unterhalb der Haftzone nach. Zur erfindungsgemäßen Herstellung einer versprödenden Verbindung zwischen einer Halbleiterscheibe und der Trägerplatte wird die Trägerplatte auf eine Temperatur von vorzugsweise 60 bis 120°C erhitzt und anschließend die Halbleiterscheibe auf die erwärmte Trägerplatte aufgelegt und nach wenigen Sekunden (Erwärmung der Scheibe) mit einem geeigneten Werkzeug gegen die Trägerplatte gepresst. Beim Abkühlen von Trägerplatte und Scheibe auf eine Temperatur etwas unterhalb der Haftzone härtet die Masse aus und schafft damit eine feste Verbindung zwischen der Halbleiterscheibe und der Trägerplatte. Es ist auch möglich, die Halbleiterscheibe statt der Trägerplatte zu erhitzen und die Halbleiterscheibe im heißen Zustand auf die Trägerplatte zu legen.

Die so hergestellte Verbindung bleibt auch unter den während einer Politur üblicherweise herrschenden Temperaturbedingungen von bevorzugt 30 bis 50°C fest.

Es werden bevorzugt mehrere Halbleiterscheiben, beispielsweise eine Anzahl von sechs auf eine Trägerplatte aufgelegt und gemeinsam oder in Gruppen gegen die Trägerplatte gepresst. Die Halbleiterscheibe wird vorzugsweise auf die Trägerplatte aufgelegt, indem sie in einem Randbereich angesaugt und in konvex verformten Zustand auf die vorgewärmte Trägerplatte fallengelassen wird und mit einer Zentrumsfläche mit Hilfe einer aufblähbaren Druckkammer gegen die Trägerplatte gedrückt wird.

Das Pressen der Halbleiterscheiben gegen die Trägerplatte kann mittels einer großen Platte als Stempel erfolgen, allerdings ist das Ausrichten der Stempelebene parallel zur Trägerplatte schwierig und bedarf einer intelligenten Regelung. Geeigneter ist die Verwendung einer über alle Halbleiterscheiben reichenden Membran, die beispielsweise mittels Gasdruck die nötige Kraft auf die Halbleiterscheiben überträgt. Als besonders einfach hat sich die Verwendung von aufblähbaren Bälgen erwiesen, die mit entsprechender Druckregelung die Kräfte sehr glerchmäßig auf die Scheibenoberfläche aufbringen. Noch einfacher und in der Wirkung noch besser ist das Pressen mittels eines Tampons, wie es im Tampondruck eingesetzt wird. Dieses Tampon ist beispielsweise ein Silikonkissen mit sehr geringer Härte, die im Bereich von 2 bis 20 Shore A liegt, bevorzugt zwischen 2 und 12 Shore A. Zweckmäßigerweise wird dem Tampon eine flache Kegelspitze oder abgerundete Spitze vorgegeben, um eine optimale Druckverteilung auf die Oberfläche der Halbleiterscheibe zu erreichen. Den Balg oder das Tampon ordnet man sinnvollerweise in einem Versatz von 120° an, so dass je 3 Halbleiterscheiben gleichzeitig gepresst werden können. Grundsätzlich lässt sich das Aufpressen auch an einzelnen Scheiben durchführen, ist aber für den Prozessfluss nicht zu bevorzugen. Der beim Arbeiten mit Druckbalg oder Tampon verwendete Druckbereich liegt zwischen 50 und 1000 mbar, bevorzugt zwischen 50 und 500 mbar. Auch Drücke von 1 bis 5 bar sind anwendbar, sie bringen jedoch keinen zusätzlichen Vorteil.

Nach der Politur der Halbleiterscheibe kann die Verbindung zwischen der Halbleiterscheibe und der Trägerplatte wieder gelöst werden. Dies geschieht bevorzugt dadurch, dass ein geeignetes Werkzeug, ähnlich einer Spachtel, einem Spatel oder einer Messerklinge, in die Klebefuge einfährt und die Halbleiterscheibe mittels der Keilwirkung absprengt. Bei den oben als bevorzugt und besonders bevorzugt beschriebenen Kitten ist Wasser, insbesondere in Verbindung mit Megaschall (600 bis 1500 kHz), in der Lage, die Reste der Stoffmischung rückstandslos von der Halbleiterscheibe und der Trägerplatte abzulösen.

Das erfindungsgemäße Verfahren zeichnet sich insbesondere dadurch aus, dass Kittschichten auf zu verbindenden Oberflächen auf einfache Art und hochpräzise hergestellt werden können und physikalisch vorgegebene Eigenheiten, die zu Defekten führen, vermieden werden.

Das erfindungsgemäße Verfahren hat den Vorteil, dass die Kittschicht beim Aufbringen so strukturiert wird, dass sowohl die Unebenheiten der Wafer-Rückseite als auch des getrockneten Kittes in die Hohlräume zwischen den "Kitt-Punkten" beim Pressen der Scheibe in den Kitt ausweichen können.

Das erfindungsgemäße Verfahren hat den Vorteil, dass die Unebenheiten des Vorprodukts als auch die beim Trocknen des Kitts aus seiner Lösung entstehenden Dämpfe in den Zwischenräumen des punktuell aufgetragenen Kitts gepuffert werden.

Das erfindungsgemäße Verfahren hat darüber hinaus den Vorteil, dass es keine Welligkeit im Submikrometer-Bereich ("waviness") auf der Oberfläche der polierten Halbleiterscheibe hinterlässt.

Das erfindungsgemäße Verfahren hat des weiteren den Vorteil, dass trotz eines niedrigen Haftzonenbereichs der Kitt bei den gewählten Poliertemperaturen so wenig elastisch ist, dass die Scheiben nicht verschwimmen, und dass beim Abkitten (Lösen der Klebverbindung) die dazu benötigte Kraft gegenüber einer ganzflächigen Verklebung wesentlich herabgesetzt werden kann, je nach Punktdichte auf ca. 1/3 bis 1/5.

Das erfindungsgemäße Verfahren hat den Vorteil, dass auch Scheiben mit großen Durchmessern, und damit verbunden großen Flächen, fixiert werden können, ohne ein Problem des Lufteinschlusses unter der Scheibe, des Scheibenverschwimmens oder von Waviness.

Das erfindungsgemäße Verfahren hat den Vorteil, dass die vom Gehalt an Lösemittel abhängige Schrumpfung des Kitts - Hauptfaktor bei der nanotopologischen Verformung der Halbleiterscheibe beim ganzflächigen Aufkitten - erheblich reduziert wird.

Das erfindungsgemäße Verfahren hat den Vorteil, dass keine Deformationen im Randbereich der fixierten Wafer, wie sie beim vollflächigen Verkleben bekannt sind, auftreten.

In den nachfolgenden Beispielen beziehen sich alle Angaben von Teilen und Prozentsätzen, soweit nicht anders angegeben, auf das Gewicht. Sofern nicht anders angegeben, werden die folgenden Beispiele bei einem Druck der umgebenden Atmosphäre, also bei etwa 1000 hPa, und bei Raumtemperatur, also etwa 22°C bzw. einer Temperatur, die sich beim Zusammengeben der Reaktanden bei Raumtemperatur ohne zusätzliche Heizung oder Kühlung einstellt, durchgeführt.

Es werden die folgenden Abkürzungen verwendet:
TP = Trägerplatte aus Aluminiumoxid-Keramik mit einem Durchmesser von 640 mm.
MM = Magic Mirror

### Vergleichsbeispiel 1

Eine ca. 30 %ige wässrige Lösung des Kitts - hergestellt durch Lösen von 3,6 kg Kolophoniumharz Bergvik M-106 in 13,9 kg deionisiertem Wasser unter Zugabe von 1,47 kg Triethanolamin (80 Gew.-% in Wasser), 450 g Nonylphenolpolyether, 1,96 kg Isopropanol und 10 g Kristallviolett - wurde auf eine TP aufgeschleudert, dass nach dem Trocknen bei 45°C eine durchgehende Schicht mit einer Schichtdicke von 6 µm erreicht wurde. Nach weiterem Heizen der TP auf eine gleichmäßige Oberflächentemperatur von 75°C wurde eine Silicium-Scheibe mit einem Durchmesser von 200 mm mit einem Vakuum-Sauger aufgelegt und mit einem Druck von 300 mbar in den Kitt eingepresst. Nach der Politur der Silicium-Oberfläche wurde der Wafer von der TP gelöst, gereinigt und auf die lokale Ebenheit der Oberfläche mittels MM untersucht. Es zeigten sich große., rundliche Helligkeitsunterschiede von einigen Millimeter (8 bis 15 mm) Länge. Die Höhe der Gebilde wurde im SQM-Gerät der Fa. KLA-Tencor mit bis zu 60 nm bestimmt.

### Beispiel 1 (Verfahrensvariante a))

Der wasserfreie Kitt - hergestellt durch Aufschmelzen von 8,9 kg Kolophoniumharz M-108, 4,2 kg Triethanolamin (80 Gew-% in Wasser) und 25 g Kristallviolett bis zur vollständiger Lösung der Komponenten und Abdampfen des Wassers bis zur Gewichtskonstanz - wurde bei 100°C auf die vorgeheizte TP aufgegossen und mittels einer Zahnrakel (Breite der Rakel 210 mm, die Zähne mit 250 µm Breite und 250 µm Abstand) gleichmäßig über die Oberfläche verteilt, wobei ca. 50 % der Fläche mit streifenförmigem Kitt bedeckt waren. Die Höhe der Kittstreifen betrug 50 µm. Die weiteren Schritte erfolgten wie in Vergleichsbeispiel 1 angegeben. Im MM waren langwellige, gerichtete Strukturen (20 bis 40 mm) zu sehen, die von der Rakelführung herrührten. Die auf den Kittprozess zurückzuführenden Strukturen wurden mit Höhen bis max. 25 nm bestimmt.

### Beispiel 2 (Verfahrensvariante b))

In einer Laboranlage wurde der schmelzflüssige Kitt, dessen Herstellung in Beispiel 1 beschrieben ist, mit einer Viskosität von 150 000 mm²/s zwischen 2 siliconisierten Trennpapieren mehrfach flächig ausgewalzt, um eine möglichst gleichmäßige Filmdicke von 30 µm zu erhalten. Nach Abziehen des einen Trennpapiers wurde die Folie auf eine TP bei 80°C mittels profilierter Walze aufgewalzt, wobei die Fläche der TP zu ca. 50 % streifig mit der Kittfolie bedeckt war. Die Höhe der Kittstreifen betrug dann etwa 50 nm. Das Aufbringen des Wafers und die weitere Verarbeitung erfolgte wie in Vergleichsbeispiel 1 beschrieben. Im MM wurden Streifen unterschiedlicher Wafer-Dicke festgestellt, die dem Abstand des Walzenprofils entsprachen. Die Höhe der eigentlichen Waviness wurde mit max. 25 nm ausgemessen.

### Beispiel 3 (Verfahrensvariante c))

Der wasserfreie Kitt, dessen Herstellung in Beispiel 1 beschrieben ist, wurde zu feinem Pulver vermahlen und auf 0,5 µm durch "Windsichten" klassiert. Dieses in einem Wirbelbett durch innere Reibung leicht elektrostatisch auf mindestens 10 kV aufzuladende Pulver wurde durch Eintauchen der TP auf deren Oberfläche sehr dünn aufgebracht, dass nahezu nur eine einschichtige Belegung erfolgte und ca. 30 % der Oberfläche von TP mit Kitt belegt ist. Nach kurzzeitigem Heizen auf Schmelztemperatur wurde der Wafer wie in Vergleichsbeispiel 1 beschrieben aufgelegt und verarbeitet. Mit dem SQM wurde die Höhe der Nanotopologie mit etwa 20 nm bestimmt, allerdings waren einige Grübchen (Dimple) auf den Scheiben, was auf eine Aggregatbildung einiger Kolophoniumkörner zurückzuführen ist.

### Beispiel 4 (Verfahrensvariante d))

Ein Metallsieb mit 530 x 420 mm Ausmaß und einer Meshzahl von 350, in dessen Mitte eine Fläche von 205 mm Durchmesser mit einem Punktmuster (Punktdurchmesser 160 µm, Punktabstand 160 µm) mittels Photolacktechnik versehen war, wurde mit einer zähflüssigen Kittmasse (Viskosität 46 000 mm²/s), hergestellt aus 500 g eines Kolophoniumharzes M-108, 239 g Triethanolamin (80 Gew.-% in Wasser), 290 g Wasser und 2 g Kristallviolett, eingerakelt. Die einzelnen Punkte wiesen im wesentlichen eine halbkugelförmige Form auf, die Oberfläche des wafers war zu ca. 25 % mit Kitt bedeckt. Die TP und der Kitt wurden auf 80°C erwärmt. Das Auflegen des Wafers und die Weiterverarbeitung erfolgte wie in Vergleichsbeispiel 1 beschrieben. Nach dem Abkitten und Reinigen der Scheibe war die Oberfläche der Halbleiterscheibe im MM defektfrei, im SQM konnten noch geringe Helligkeitsunterschiede festgestellt werden, deren Höhe zu max. 10 nm ausgemessen wurden. Fig.4 zeigt das von einem die Nanotopologie auflösenden Oberflächen-Inspektionsgerät erzeugte Bild einer gemäß Beispiel 4 polierten Halbleiterscheibe. Zum Vergleich ist in Fig.5 ein entsprechendes Bild einer Halbleiterscheibe dargestellt, die während des Polierens über einen geschlossenen Kittfilm mit der Trägerplatte verbunden war. Das kontrastärmere Erscheinungsbild von Fig.4 weist auf geringer ausgeprägte Unebenheiten hin. Ein im Zentrum von Fig.5 erkennbarer Centermark-Fehler 8 ist in Fig.4 überhaupt nicht vorhanden.

### Beispiel 5 (Verfahrensvariante e))

In den entleerten Druckerkopf eines Hewlett Packard DeskJet 500 Druckers wurde ein relativ dünnflüssiger Kitt (Viskosität 22 mm²/s), dessen Herstellung in Vergleichsbeispiel 1 beschrieben ist, eingefüllt. Durch Abrastern einer Fläche von 80 mm x 80 mm wurden die einzelnen Kleberpunkte auf der vorgeheizten Modell-Trägerplatte von 200 mm Durchmesser aufgetragen und eine 3"-Si-Scheibe nach dem in Vergleichsbeispiel 1 beschriebenen Verfahren aufgelegt und verarbeitet. Die Nanotopologie-Qualität war der im Beispiel 4 mit 5 bis 9 nm Höhenunterschied entsprechend.

## Patentansprüche

1. Verfahren zur Montage von planaren Werkstücken und zur Politur der Werkstücke, wobei zur Vorbereitung der Politur zwischen dem planaren Werkstück und einer Trägerplatte durch einen Kitt eine temperaturabhängig klebende und versprödende Verbindung geschaffen wird, und das Werkstück poliert wird, und dass die zu verbindenden Oberflächen der Trägerplatte und des planaren Werkstücks nach einem Auflegen des Werkstücks auf die Trägerplatte jeweils nur zum Teil mit Kitt (1, 2) bedeckt sind.

2. Verfahren nach Anspruch 1, **dadurch gekennzeichnet, dass** der Kitt (1, 2) als Punktmuster auf eine (4) der zu verbindenden Oberflächen aufgetragen wird.

3. Verfahren nach Anspruch 1, **dadurch gekennzeichnet, dass** der Kitt (1, 2) als Streifenmuster auf eine (4) der zu verbindenden Oberflächen aufgetragen wird.

4. Verfahren nach Anspruch 1, **dadurch gekennzeichnet, dass** der Kitt (1, 2) auf eine (4) der zu verbindenden Oberflächen gedruckt wird.

5. Verfahren nach einem der Ansprüche 1 bis 4, **dadurch gekennzeichnet, dass** sich der Kitt (1, 2) mit einer Höhe von 1 bis 50 µm von einer (4) der zu verbindenden Oberflächen abhebt.

6. Verfahren nach einem der Ansprüche 1 bis 5, **dadurch gekennzeichnet, dass** die Bedeckung des Werkstücks mit Kitt (1, 2) in einem Randbereich des Werkstücks größer ist als in einem Zentrumsbereich des Werkstücks.

7. Verfahren nach einem der Ansprüche 1 bis 6, **dadurch gekennzeichnet, dass** es sich bei dem Kitt (1, 2) um eine Stoffmischung auf der Basis von Kolophoniumharz handelt.

8. Verfahren nach einem der Ansprüche 1 bis 6, **dadurch gekennzeichnet, dass** es sich bei dem Kitt (1, 2) um ein Copolymer auf der Basis von Pyrrolidon handelt.

9. Verfahren nach einem der Ansprüche 1 bis 8, **dadurch gekennzeichnet, dass** maximal 75 % der zu verbindenden Oberflächen mit Kitt (1, 2) bedeckt sind, wenn das Werkstück auf der Trägerplatte aufliegt.

10. Verfahren nach Anspruch 9, **dadurch gekennzeichnet, dass** 10 bis 50 % der zu verbindenden Oberflächen mit Kitt (1, 2) bedeckt sind.

11. Verfahren nach einem der Ansprüche 1 bis 10, **dadurch gekennzeichnet, dass** das Werkstück beim Auflegen auf die Trägerplatte in einem konvex verformten Zustand auf die Trägerplatte fallengelassen wird.

12. Verfahren nach einem der Ansprüche 1 bis 11, **dadurch gekennzeichnet, dass** das Werkstück nach dem Auflegen auf die Trägerplatte mit einem Druck von 50 bis 1000 mbar gegen die Trägerplatte gepresst wird.

## Claims

1. Method for mounting planar workpieces and for polishing the workpieces, in which, to prepare for the polishing, a join which adheres and becomes brittle in a temperature-dependent manner is created between the planar workpiece and a support plate by a wax, and the workpiece is polished and that the surfaces of the support plate and of the planar workpiece which are to be joined, after the workpiece has been laid onto the support plate, are only partially covered with wax (1, 2).

2. Method according to Claim 1, **characterized in that** the wax (1, 2) is applied to one (4) of the surfaces to be joined as a pattern of spots.

3. Method according to Claim 1, **characterized in that** the wax (1, 2) is applied to one (4) of the surfaces to be joined as a pattern of strips.

4. Method according to Claim 1, **characterized in that** the wax (1, 2) is printed onto one (4) of the surfaces which are to be joined.

5. Method according to one of Claims 1 to 4, **characterized in that** the wax (1, 2) rises up by a height of from 1 to 50 µm from one (4) of the surfaces to be joined.

6. Method according to one of Claims 1 to 5, **characterized in that** the covering of the workpiece with wax (1, 2) in an edge region of the workpiece is greater than in a central region of the workpiece.

7. Method according to one of Claims 1 to 6, **characterized in that** the wax (1, 2) is a mixture of substances based on colophony resin.

8. Method according to one of Claims 1 to 6, **characterized in that** the wax (1, 2) is a copolymer based on pyrrolidone.

9. Method according to one of Claims 1 to 8, **characterized in that** at most 75% of the surfaces to be joined are covered with wax (1, 2) when the workpiece is resting on the support plate.

10. Method according to Claim 9, **characterized in that** from 10 to 50% of the surfaces to be joined is covered with wax (1, 2).

11. Method according to one of Claims 1 to 10, **characterized in that** the workpiece, when it is being laid onto the support plate, is dropped onto the support plate in a convexly deformed state.

12. Method according to one of Claims 1 to 11, **characterized in that** the workpiece, after it has been placed onto the support plate, is pressed onto the support plate under a pressure of from 50 to 1000 mbar.

## Revendications

1. Procédé pour le montage de pièces planes et pour le polissage des pièces, dans lequel, pour la préparation de la composition de polissage, on produit entre la pièce plane et une plaque de support, par le biais d'un mastic, une liaison fragilisante et collante en fonction de la température, et la pièce est polie, et où les surfaces à connecter de la plaque de support et de la pièce plane sont revêtues à chaque fois seulement en partie avec le mastic (1, 2) après une application de la pièce sur la plaque de support.

2. Procédé selon la revendication 1, **caractérisé en ce que** le mastic (1, 2) est appliqué sous forme de motif ponctuel sur une (4) des surfaces à connecter.

3. Procédé selon la revendication 1, **caractérisé en ce que** le mastic (1, 2) est appliqué sous forme de motif en ruban sur une (4) des surfaces à connecter.

4. Procédé selon la revendication 1, **caractérisé en ce que** le mastic (1, 2) est pressé sur une (4) des surfaces à connecter.

5. Procédé selon l'une quelconque des revendications 1 à 4, **caractérisé en ce que** le mastic (1, 2) est rehaussé d'une hauteur de 1 à 50 µm par rapport à une (4) des surfaces à connecter.

6. Procédé selon l'une quelconque des revendications 1 à 5, **caractérisé en ce que** le revêtement de la pièce avec le mastic (1, 2) est plus important dans une région de bord de la pièce que dans une région centrale de la pièce.

7. Procédé selon l'une quelconque des revendications 1 à 6, **caractérisé en ce que** le mastic (1, 2) est un mélange de substances à base de résine de colophane.

8. Procédé selon l'une quelconque des revendications 1 à 6, **caractérisé en ce que** le mastic (1, 2) est un copolymère à base de pyrrolidone.

9. Procédé selon l'une quelconque des revendications 1 à 8, **caractérisé en ce qu'**au maximum 75% des surfaces à connecter sont recouvertes de mastic (1, 2) lorsque la pièce repose sur la plaque de support.

10. Procédé selon la revendication 9, **caractérisé en ce que** de 10 à 50% des surfaces à connecter sont revêtues de mastic (1, 2).

11. Procédé selon l'une quelconque des revendications 1 à 10, **caractérisé en ce que** l'on fait tomber la pièce sur la plaque de support dans un état déformé sous forme convexe lors de la pose sur la plaque de support.

12. Procédé selon l'une quelconque des revendications 1 à 11, **caractérisé en ce que** la pièce est pressée avec une pression de 50 à 1000 mbars contre la plaque de support lors de sa pose sur la plaque de support.
